# EUROPÄISCHE PATENTSCHRIFT

(11) **EP 1 029 389 B1**
(45) Veröffentlichungstag und Bekanntmachung des Hinweises auf die Patenterteilung: **19.09.2001**
(21) Anmeldenummer: 98958208.5
(22) Anmeldetag: 21.10.1998
(51) Int. Cl.: H02B 1/21, H05K 7/14

(54) **AUFBAUSYSTEM FÜR VERBRAUCHERABZWEIGE MIT STEHENDER VERDRAHTUNG**
ASSEMBLY SYSTEM FOR LOAD FEEDERS WITH PERMANENT WIRING
SYSTEME STRUCTURAL POUR CIRCUITS DE BRANCHEMENT DE CONSOMMATEURS A CABLAGE FIXE

(30) Priorität: 03.11.1997 DE 19748531
(43) Veröffentlichungstag der Anmeldung: 23.08.2000
(73) Patentinhaber: SIEMENS AKTIENGESELLSCHAFT, 80333 München (DE)
(72) Erfinder: KAADEN, Peter, D-92421 Schwandorf (DE); BURY, Joachim, D-92245 Kümmersbruck (DE)
(86) Internationale Anmeldenummer: DE9803094
(87) Internationale Veröffentlichungsnummer: WO9923737

(56) Entgegenhaltungen:
- DE-U- 29 607 525
- US-A- 5 629 831

## Beschreibung

Die Erfindung bezieht sich auf einen Verbraucherabzweig zum Schalten und Schützen eines in einem Hauptstromkreis für Spannungen über 100 Volt anschließbaren Verbrauchers, umfassend eine Abzweig-Baugruppe und ein Trägerteil mit ersten Steckanschlüssen zum Anschluß an einen Energiebus mit Hauptstromleitungen, an einen Datenbus und erforderlichenfalls an einen Hilfsenergie-Bus, wobei die Abzweig-Baugruppe auf dem Trägerteil mechanisch adaptierbar und über erste Gegensteckanschlüsse mit den ersten Steckanschlüssen kontaktierbar ist.

Ein gattungsgemäßer Verbraucherabzweig ist aus der EP 0 753 916 A3 bekannt. Die Hauptstromleitungen, der Daten-bus und der Hilfsenergiebus werden hier als Sammelschiene im Bodenteil des Verbraucherabzweigs verlegt, nachdem dieses im Schaltschrank montiert ist. Dies bedeutet, daß für die Montage von vorn herein klar sein muß, welche Schaltgeräte an welcher Stelle im Schaltschrank vorzusehen sind. Das bekannte Sammelschienen-Adaptersystem dient zum Anschluß eines Motorabzweigs und weist an seiner Oberseite Hutschienen auf, auf die ein Schütz und ein Leistungsschalter aufschnappbar sind.

Aus der WO 96/42188 ist eine kommunikationsfähige Schaltgeräteeinheit bekannt, die für einen Schaltschrank mit einem Datenbus eine einfache Adaptierung und Kontaktierung von Schaltgeräten in Verbindung mit einer zur Datenkommunikation erforderlichen Elektronik schafft. Die Schaltgeräteeinheit besteht aus einem Geräteträger, auf dem mehrere Schaltgeräte über eine Normprofilschiene adaptierbar sind, sowie einer Kommunikationseinheit, die am Geräteträger gehalten ist und Steckkontakte aufweist, über die die elektrische Ansteuerung der Schaltgeräte erfolgt. Die Schaltgeräteeinheit kann z.B. ein Schütz und einen Leistungsschalter umfassen. Wird ein weiteres Schaltgerät benötigt, wird der Geräteträger um ein Geräteträger-Erweiterungsteil erweitert. An der Rückwand des Geräteträgers der Schaltgeräteeinheit liegen Hauptstromanschlüsse zum Anschluß, an ein dreiphasiges Sammelschienensystem. Die Schaltgeräteeinheit wird durch Einhängen an den Sammelschienen zugleich gehaltert und kontaktiert. Die Übergabe der Daten an die Elektronik im Kommunikationsmodul erfolgt über einen Busstecker oder durch Durchdringungskontaktierung einer Busleitung direkt am Kommunikationsmodul.

Bei Automatisierungsgeräten ist es wie in der EP 0 236 711 A2 ausgeführt bekannt,zur Adaptierung von Ein-/Ausgabe-Baugruppen zu verwenden, die auf Tragschienen aufschnappbar sind und die über zusätzliche Steuerleitungen miteinander verbindbar sind. Die Baugruppenträger sind hier einzeln als modulare, eine Anpassungsschaltung aufweisende Baugruppenträger ausgebildet. Mechanisch mit dem Baugruppenträger ist ein Anschlußblock für die externe Verdrahtung verbunden. Anschlußblock und Baugruppenträger sind über Steckverbindung mit den einzelnen Baugruppen verbindbar.

Die Anpassungsschaltung ist hier als Schaltungsplatine im Baugruppenträger ausgebildet. Auf der Schaltungsplatine sind Buchsenleisten zum Verbinden mit Steckanschlüssen der Ein-/Ausgabe-Baugruppen. Zum Verbinden der modularen Baugruppenträger untereinander dient eine Steckerleiste, die an der Schaltungsplatine angeschlossen mit einem Bandkabel in Verbindung steht, an dem seinerseits eine Buchsenleiste angeschlossen ist. Über diese ist die elektrische Verbindung der Steckerleiste des benachbarten Baugruppenträgers herstellbar.

Die Baugruppenträger lassen sich Seite an Seite durch Verhakkung von seitlich vorstehenden Nasen in angepaßt ausgeführten Ausnehmungen in den Gehäusen der Baugruppenträger miteinander verbinden. Davon unabhängig erfolgt die elektrische Verbindung.

In der noch unveröffentlichten deutschen Patentanmeldung 19734709.6 ist ein Schaltgerätesystem mit modular aufgebautem Energiebus offenbart. Mehrere Schaltgeräte werden hier über dieselbe Energieeinspeisung betrieben. Hierzu ist jedem Schaltgerät ein Energiebusmodul zugeordnet, das jeweils einen Energiebus-Abschnitt aufweist, über den das zugehörige Schaltgerät mit der Energieeinspeisung elektrisch verbindbar ist. Dabei sind die Energiebus-Abschnitte miteinander zu einer durchgehenden Verteilerschiene verbunden. Die Energieeinspeisung ist mindestens an einen der Energiebus-Abschnitte anschließbar.

Der Erfindung liegt die Aufgabe zugrunde, einen Verbraucherabzweig der oben genannten Art zu schaffen, der im Rahmen eines Aufbausystems bezüglich Montage- und Prüfaufwand verbessert ist und einfache Erweiterungsmöglichkeiten bei Reduzierung des Verdrahtungsaufwands bietet.

Die Aufgabe wird dadurch gelöst, daß das Trägerteil als modulares erstes Basis-Unterteil eines modular erweiterbaren Trägersystems mit einem Leitungs- und Bussystem zur Bildung eines Energie-, Hilfsenergie- und Daten-Busses aufgebaut ist und hierzu im ersten Basis-Unterteil erste Leitungs- und/oder Busabschnitte mit zugehörigen zweiten Steck- und Gegensteckanschlüssen integriert sind, über die zweite Leitungs- und/ oder Busabschnitte über zugehörige dritte Steck- und Gegensteckanschlüsse eines entsprechend ausgeführten zweiten Basis-Unterteils bei Erweiterung des Trägersystems kontaktierbar sind. Die erfindungsgemäße Ausführung bringt folgende Vorteile mit sich:
- Platzreduzierung im Schaltschrank
- Verringerung des Montage-,Verdrahtungs-, Prüf-, Projektierungs- und Serviceaufwands.

Die Lösung ermöglicht eine Steuerverdrahtung und Energieverteilung für eine dezentrale Peripherie und Verbraucherabzweige in einem Arbeitsgang. Es werden Datenbus, Hilfsenergiebus, Energiebus und mechanische Trägereinheit zu einem vormontierbaren Trägersystem zusammengeführt, das durch Aneinanderreihung beliebig verlängert werden kann. Die Ein- und Ausgabe-baugruppen sowie die Verbraucherabzweige können als gleichwertige dezentrale Peripherie in Reihe aufgebaut, projektiert und in Betrieb gesetzt werden.

Eine vorteilhafte Ausgestaltung der Erfindung wird erreicht, wenn die zweiten Steckanschlüsse bzw. Gegensteckanschlüsse des ersten Basis-Unterteils unmittelbar mit den dritten Steckanschlüssen bzw. Gegensteckanschlüssen eines zweiten Basis-Unterteils bei dessen Anreihung Seite an Seite an das erste Basis-Unterteil kontaktieren. Die Kontaktierung erfolgt hier in Verbindung mit der mechanischen Kopplung zweier Basis-Unterteile, d.h. in einem einzigen Arbeitsgang.

Gehört das zweite Basis-Unterteil zu einer Ein- bzw. Ausgabe-baugruppe, so läßt sich hierdurch eine einfache Zusammenführung eines Abzweigs mit einer Ein- bzw. Ausgabebaugruppe im Schaltschrank auf engem Raum erreichen.

Eine besonders platzsparende Anordnung wird erreicht, wenn die den ersten Leitungs- und/oder Busabschnitten zugehörigen zweiten Steck- und Gegensteckanschlüsse an Seitenwänden des Basis-Unterteils vorgesehen sind.

Im Hinblick auf einen möglichst geringen Prüf- und Serviceaufwand erweist es sich als vorteilhaft, wenn das Basis-Unterteil ein abnehmbares Energiebus-Modul mit Energiebus-Abschnitten aufweist, die im Zuge eines Hauptstromkreises liegen, über den ein Verbraucher an den Verbraucherabzweig anschließbar ist.

Eine besonders einfache Realisierung des Datenbusses ist gegeben, wenn dieser durch eine Leiterplatte mit Strombahnen realisiert ist, die am einen Ende zu einem Steck- und am anderen Ende zu einem Gegensteckanschluß zusammengefaßt sind.

Um eine einfache elektrische Anbindung einer Abzweig-Baugruppe an den Datenbus zu erreichen, ist es vorteilhaft, wenn über einen Steckanschluß in Verbindung mit den Strombahnen der Leiterplatte eine T-Funktionalität zum Anschluß der Abzweigbaugruppe an den Datenbus hergestellt ist.

Eine besonders einfache Ausgestaltung der Abzweig-Baugruppe ist gegeben, wenn diese ein Schütz, einen Leistungsschalter und eine Elektronik umfaßt, die über den Datenbus empfangbare Signale in Steuersignale für das Schütz und/oder den Leistungsschalter umsetzt bzw. Signale vom Schütz oder Leistungsschalter auf den Datenbus zurückmeldet.

Eine weitere vorteilhafte Ausgestaltung besteht, wenn das Basis-Unterteil einen Führungsschacht mit Steckanschlüssen zum Anschluß an den Energiebus aufweist und die Abzweig-Baugruppe mit einem in den Führungsschacht einführbaren, in seinen Abmessungen diesem angepaßten Einführteil mit Gegensteckanschlüssen versehen ist, die bei der mechanischen Adaptierung der Abzweig-Baugruppe auf dem Basis-Unterteil mit den Steckanschlüssen kontaktieren.

Ein Ausführungsbeispiel der Erfindung wird im folgenden anhand einer Zeichnung näher erläutert. Es zeigen:
- FIG 1: eine aus mehreren Ein-/Ausgabe-Baugruppen und einem Verbraucherabzweig modular aufgebaute Schalteinheit,
- FIG 2: einen aus einem Basis-Unterteil und einer Abzweig-Baugruppe zusammensetzbaren Verbraucherabzweig gemäß FIG 1,
- FIG 3: ein Energiebus-Modul eines Basis-Unterteils mit Steckkontakt und Gegensteckkontakt des Verbraucherabzweigs,
- FIG 4: eine Explosionsdarstellung eines dreiphasigen Energiebus-Moduls,
- FIG 5: die wesentlichen Bestandteile der Abzweig-Baugruppe,
- FIG 6: eine Seitenansicht des Verbraucherabzweigs im montierten und kontaktierten Zustand,
- FIG 7: eine Seitenansicht eines Verbraucherabzweigs mit einer vom Datenbus abgetrennten Abzweig-Baugruppe in Parkstellung,
- FIG 8: einen Verbraucherabzweig im kontaktierten Zustand,
- FIG 9: einen Verbraucherzweig mit nicht kontaktiertem Datenbus-Stecker, mit der Abzweig-Baugruppe in Parkstellung,
- FIG 10: eine rechtsseitige perspektivische Ansicht eines nach oben offenen Basis-Unterteils für eine Verbraucherabzweig mit angereihtem und kontaktiertem Basis-Unterteil für eine Ein- bzw. Ausgabe-Baugruppe und
- FIG 11: eine linksseitige Ansicht eines nach oben offenen Basis-Unterteils für einen Verbraucherabzweig.

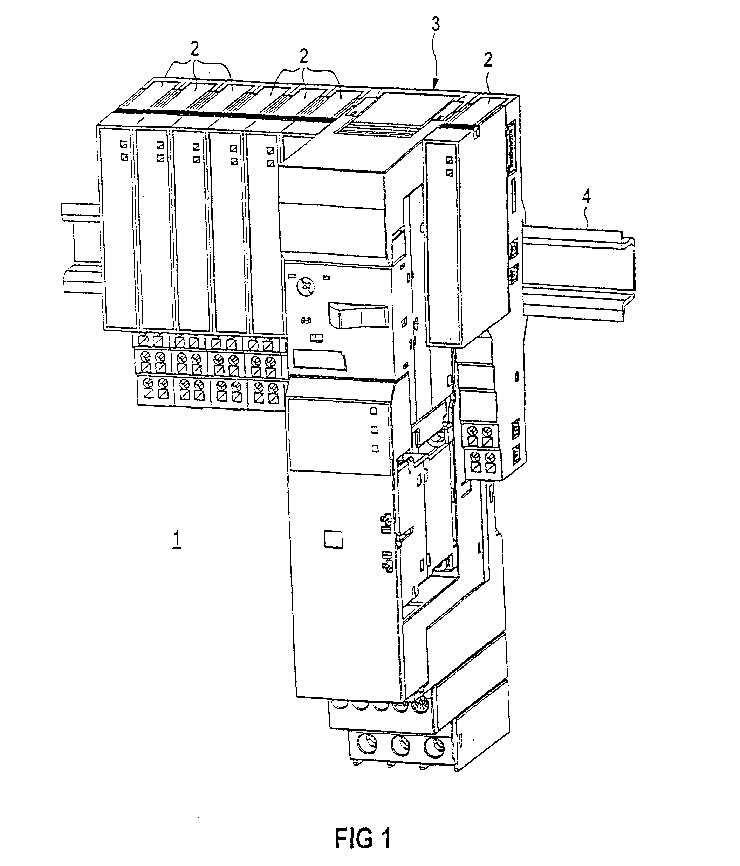

Die in FIG 1 dargestellte Schalteinheit 1 ist aus mehreren digitalen Eingabe- bzw. Ausgabe-Baugruppen 2 und einem Verbraucherabzweig 3 modular zusammengesetzt, die bündig aneinander gereiht jeweils auf einer Hutschiene 4 aufgeschnappt sind. Der modulare Aufbau ermöglicht es, die Schalteinheit 1 angepaßt an die jeweiligen Systemanforderungen mit einer entsprechenden Anzahl an Eingabe- bzw. Ausgabe-Baugruppen 2 und Verbraucherabzweigen 3 als gleichwertige dezentrale Peripherie in Reihe aufzubauen, zu projektieren und in Betrieb zu setzen.

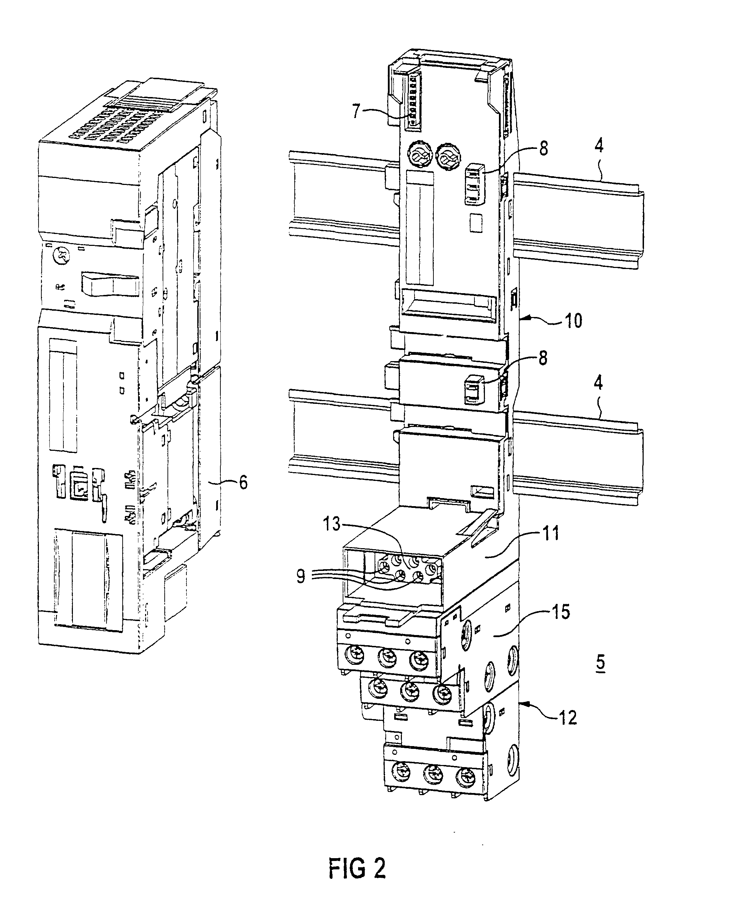

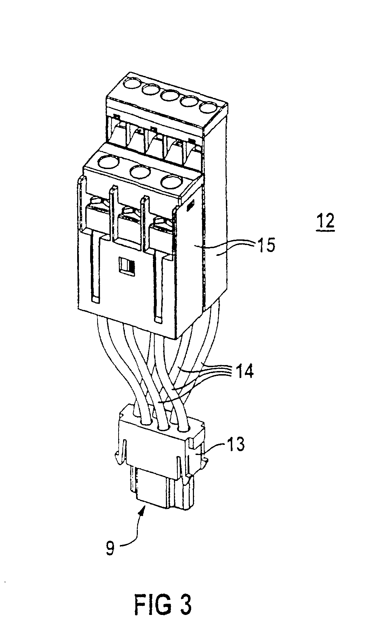

Der Verbraucherabzweig 3 besteht gemäß FIG 2 im wesentlichen aus einem Basis-Unterteil 5 und einer auf diesem verrastbaren Abzweig-Baugruppe 6 in derselben Baubreite. In dem als Trägereinheit dienenden Basis-Unterteil 5 sind weiterhin ein Datenbus, mindestens ein Hilfsenergie-Bus und ein Energiebus zusammengeführt, die hier nicht sichtbar im Gehäuse-Innenraum des Basis-Unterteils 5 liegen. FIG 2 zeigt eine Steckleiste 7 zum elektrischen Anschluß der Abzweig-Baugruppe 6 an den Datenbus, Steckanschlüsse 8 zum Anschluß an einen Hilfsenergie-Bus und Steckanschlüsse 9 zum Anschluß der Abzweig-Baugruppe 6 an den Energiebus. Das Basis-Unterteil 5 ist aus einem L-förmigen, hier auf zwei Hutschienen 4 aufgeschnappten Trägerceil 10 mit einem Führungsschacht 11 sowie einem daran ankoppelbaren Energiebus-Modul 12 wie dargestellt zusammengesetzt. Das Energiebus-Modul 12 weist einen im Führungsschacht 11 verrastbaren Stecker 13 mit den Steckanschlüssen 9 auf, die über Hauptstromleitungen 14 gemäß FIG 3 mit hier nicht dargestellten Energiebus-Abschnitten im Gehäuse 15 des Energiebus-Moduls 12 verbunden sind.

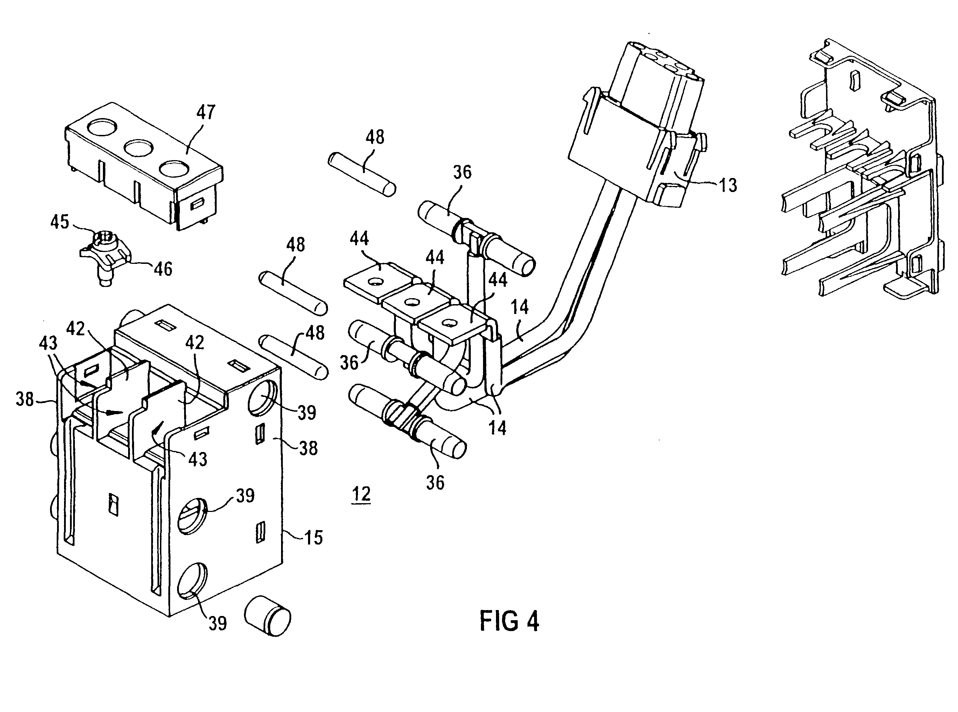

FIG 4 zeigt in einer Explosionsdarstellung den grundsätzlichen Aufbau eines Anschluß- und Verteilerbausteins bzw. Energiebus-Moduls 12. In dem Gehäuse 15 sind durch Seiten- 38 und Trennwände 42 drei Kammern 43 zur Aufnahme von drei Anschlußklemmen gebildet, die jeweils aus einer Anschlußplatte 44, einer Anschlußschraube 45 und einer Anschlußscheibe 46 bestehen. Die Berührungssicherheit wird durch eine die Kammern 43 abdeckende, auf das Gehäuse 41 aufsteckbare Schutzkappe 47 gewährleistet. An jeder Anschlußplatte 44 ist ein von Seitenwand 38 zu Seitenwand 38 reichender, das heißt, querverlaufender Energiebus-Abschnitt 36 angeschlossen, der über eine Öffnung 39 in der Seitenwand 38 bedarfsweise mit einem Energiebus-Abschnitt 36 eines daneben liegenden Energiebus-Moduls 12 über geeignete Steckelemente 48 elektrisch verbindbar ist.

Auf diese Weise kann modulartig ein Energiebus mit drei durchgehenden Verteilerschienen aufgebaut werden. Außerdem ist an jeder Anschlußplatte 44 eine Verbindungsleitung 14 zur elektrischen Verbindung mit den Anschlußklemmen des jeweils zugeordneten Schaltgeräts angeschlossen. Der modulartige Aufbau des Energiebusses bietet den Vorteil einer dem Anwendungsfall entsprechenden Anpassung, wobei es genügt, die einspeisende Energieleitung nur an einen Energiebus-Abschnitt 36 über die Anschlußklemmen eines der miteinander verbundenen Energiebus-Module 12 anzuschließen. Wie FIG 4 zeigt, ist zum Anschluß der Verbindungsleitungen 14 an das Schaltgerät der Stecker 13 vorgesehen.

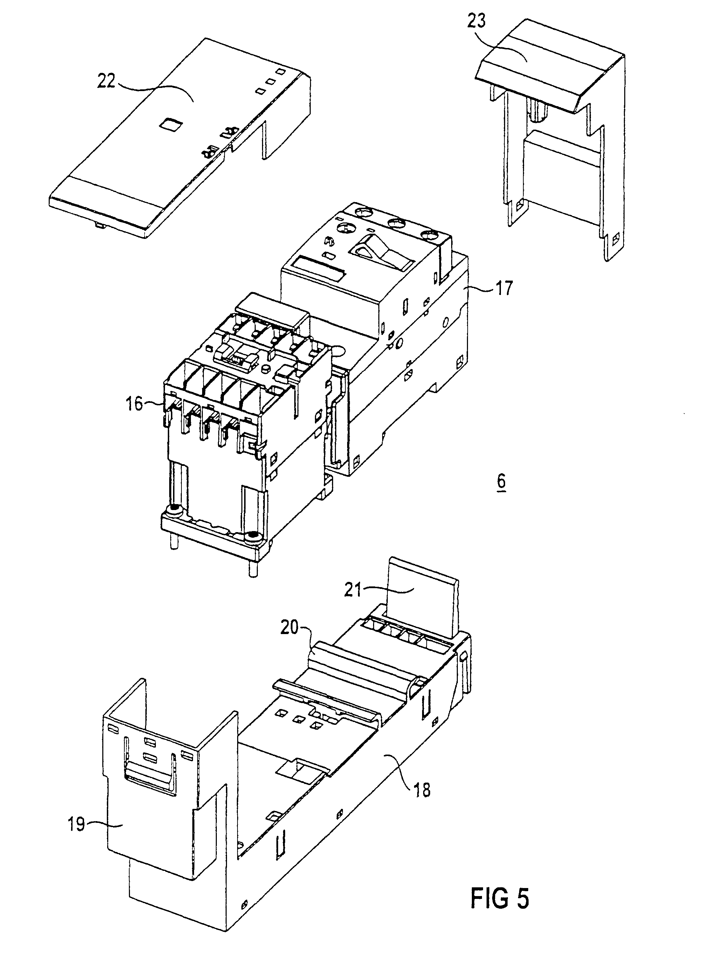

Die Abzweig-Baugruppe 6 besteht gemäß FIG 5 im wesentlichen aus einem Schütz 16, einem Leistungsschalter 17 und einem Zwischenträger 18 zur mechanischen Adaptierung von Schütz 16 und Leistungsschalter 17. Der Zwischenträger 18 ist der L-Form des Trägerteils 10 angepaßt und mit einem abstehenden Schenkel sowie einem zum Führungsschacht 11 formschlüssigen Rechteck-Kanal 19 ausgeführt, der beim Aufsetzen der Abzweig-Baugruppe 6 gemäß FIG 2 auf das Basis-Unterteil 5 in den Führungsschacht 11 gleitet, wodurch die Abzweig-Baugruppe 6 zur Verrastung und Kontaktierung in die gewünschte Position geführt wird. Im Rechteck-Kanal 19 liegen hier nicht dargestellte Gegensteckanschlüsse, über die mit der mechanischen Adaptierung der Abzweig-Baugruppe 6 zugleich eine Kontaktierung der Anschlüsse 9 zum Energiebus erfolgt. Der Führungsschacht 11 erfüllt also die beiden Funktionen der Aufnahme der elektrischen Steckverbindungen und der Vorzentrierung für die Zuordnung der Abzweig-Baugruppe 6 zum Basis-Unterteil 5.

Auf der Vorderseite des Zwischenträgers 18 ist ein Hutschienen-Abschnitt 20 zum Aufrasten des Leistungsschalters 17 vorgesehen. An dem dem Rechteck-Kanal 19 abgewandten Ende des Zwischenträgers 18 ist ein Rasthaken 21 angebracht, der zur Verrastung der Abzweig-Baugruppe 6 auf dem Basis-Unterteil 5 dient. Die Abzweig-Baugruppe 6 weist außerdem eine Frontabdeckung 22 und eine Seitenabdeckung 23 auf, die als Berührschutz dienen.

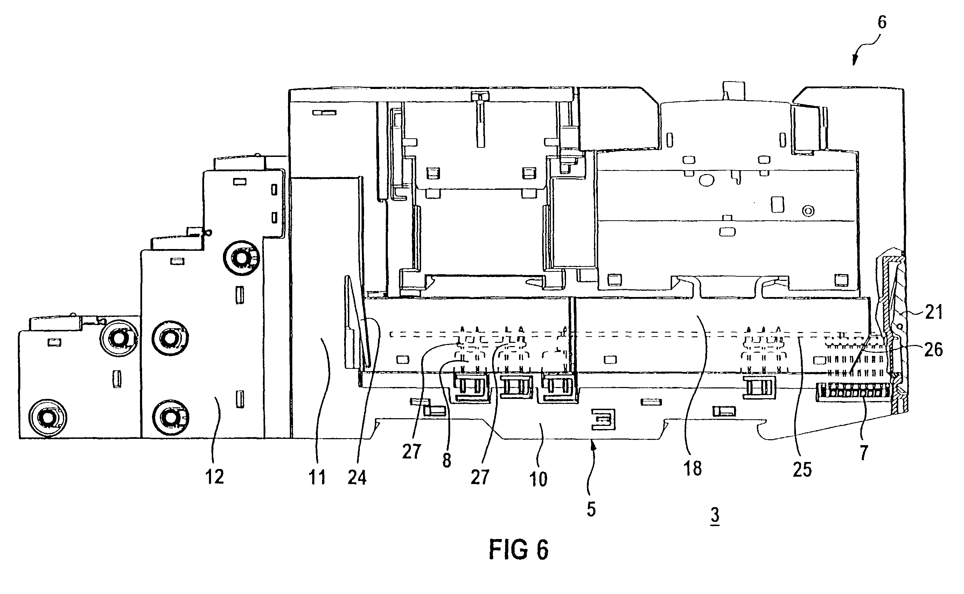

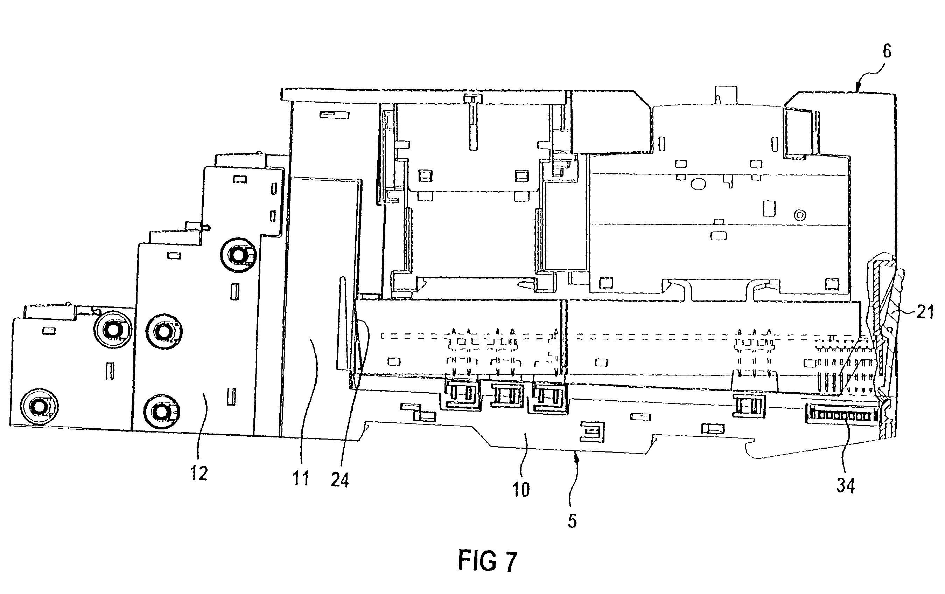

In FIG 6 ist eine Seitenansicht des Verbraucherabzweigs 3 im adaptierten und kontaktierten Zustand dargestellt, in dem eine Rastfeder 24 am Führungsschacht 11 die Abzweig-Baugruppe 6 zum Basis-Unterteil 5 verriegelt. Ein Lösen der Abzweig-Baugruppe ist erst nach Betätigung des Rasthakens 21 möglich, wodurch zunächst die Positionsänderung der Abzweig-Baugruppe 6 in eine Parkstellung gemäß FIG 7 erfolgt, mit Abschalten des Verbrauchers über das Schütz der Abzweig-Baugruppe; erst danach können die Steckverbindungen der Abzweig-Baugruppe vom Basis-Unterteil getrennt und die Abzweig-Baugruppe abgezogen werden.

In dem Zwischenträger 18 ist eine Leiterplatte 25 mit der zum Signalaustausch erforderlichen Anpassungselektronik angeordnet. Die zum Anschluß an den Datenbus sowie den Hilfsenergie-Bus erforderlichen Gegensteckanschlüsse 26, 27, die hier als Stiftleiste und durch Messerkontakte ausgebildet sind, sind direkt mit der Leiterplatte 25 verlötet und kontaktieren an der Rückseite der Abzweig-Baugruppe 6 die entsprechenden Steckanschlüsse 7,8 am Basis-Unterteil 5.

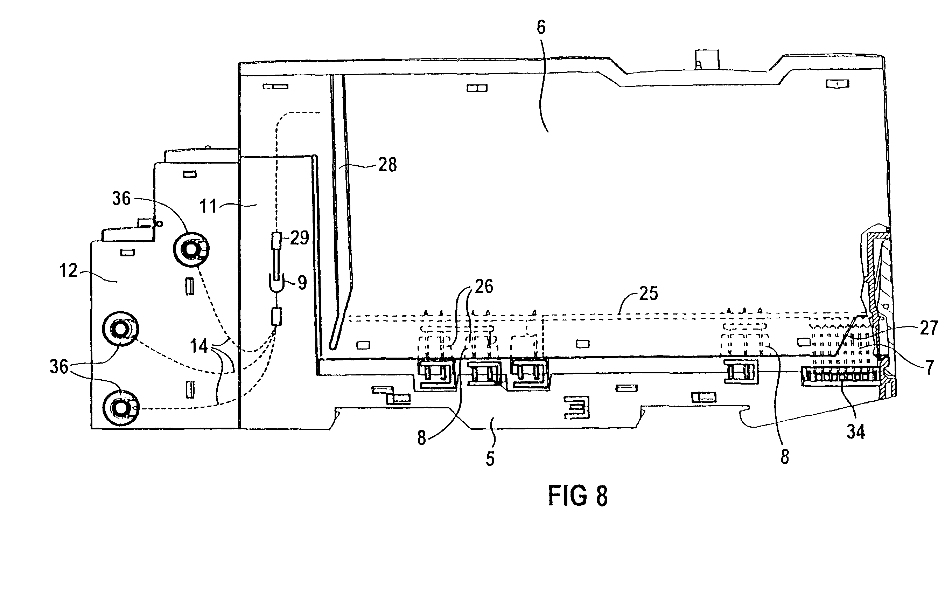

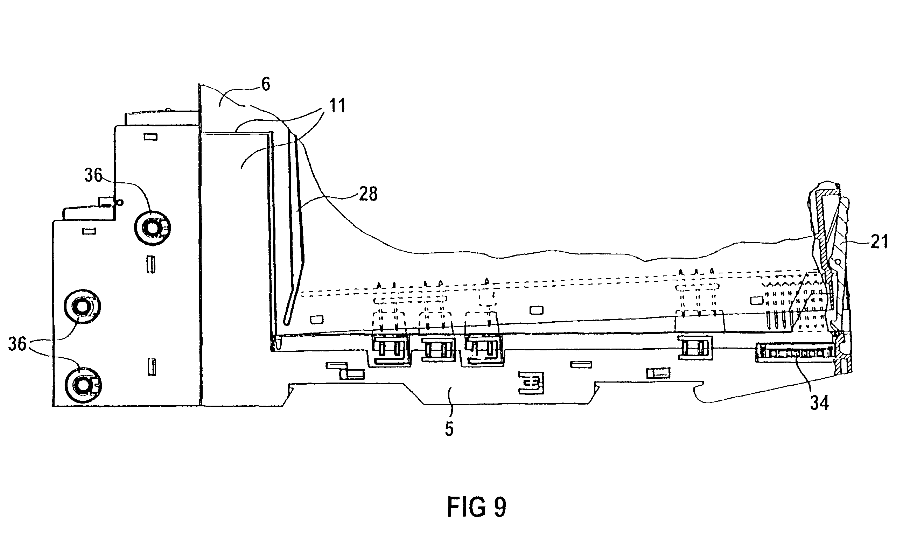

In der in FIG 7 dargestellten Parkstellung sind die Verbindungen zum Daten-Bus aufgetrennt und der Rasthaken 21 steht in Vorraststellung. Durch die Ausdrehbewegung drückt die Abzweig-Baugruppe 6 die Rastfeder 24 zurück, wodurch die Verriegelung zum Basis-Unterteil 5 aufgehoben wird. Erst dann läßt sich die Abzweig-Baugruppe 6 vom Basis-Unterteil abziehen. Die Drehbewegung wird durch Nutzung der Materialeigenschaften und einen Gelenk- bzw. Drehmechanismus erreicht, der gemäß FIG 8 und 9 durch konstruktive Ausprägung des Gehäuses der Abzweig-Baugruppe 6, z.B. durch einen Schlitz 28, realisiert sein kann. Dabei wird für eine Federelementausprägung des Zwischenträgers 18, zur Ausdrehung der Abzweig-Baugruppe 6 gesorgt.

In FIG 8 ist unter anderem auch die Steckverbindung zu den Steckanschlüssen 9 über Kontaktstifte 29 als Gegenstückanschlüsse zu den Energiebus-Abschnitten 36 angedeutet.

Die Abzweig-Baugruppe 6 muß nicht notwendigerweise aus einem Schütz und einem Leistungsschalter aufgebaut sein. Es ist ebenso ein beliebiger Aufbau, z.B. auch eine elektronische Schaltung mit den entsprechenden Funktionen Überlastschutz, Kurzschlußschutz und betriebsmäßiges Schalten denkbar.

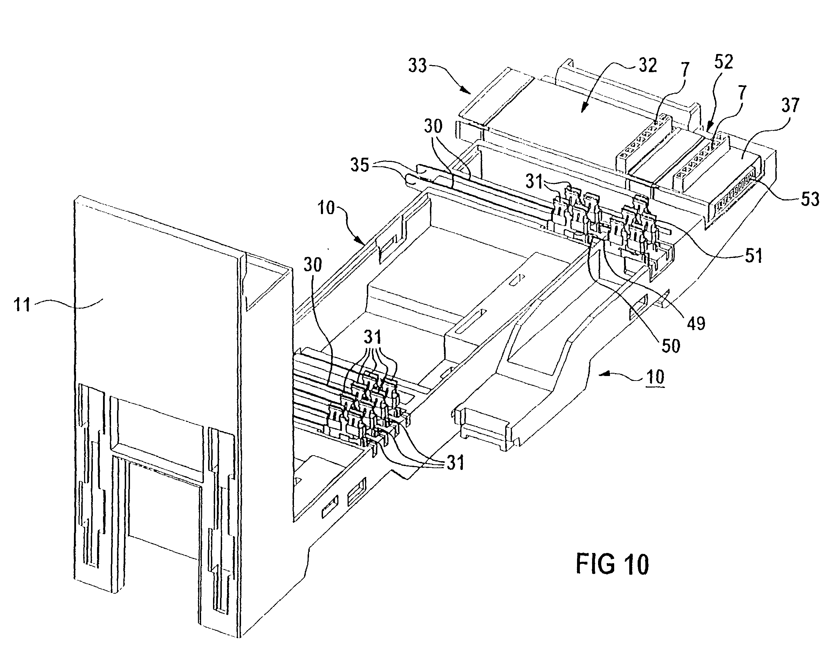

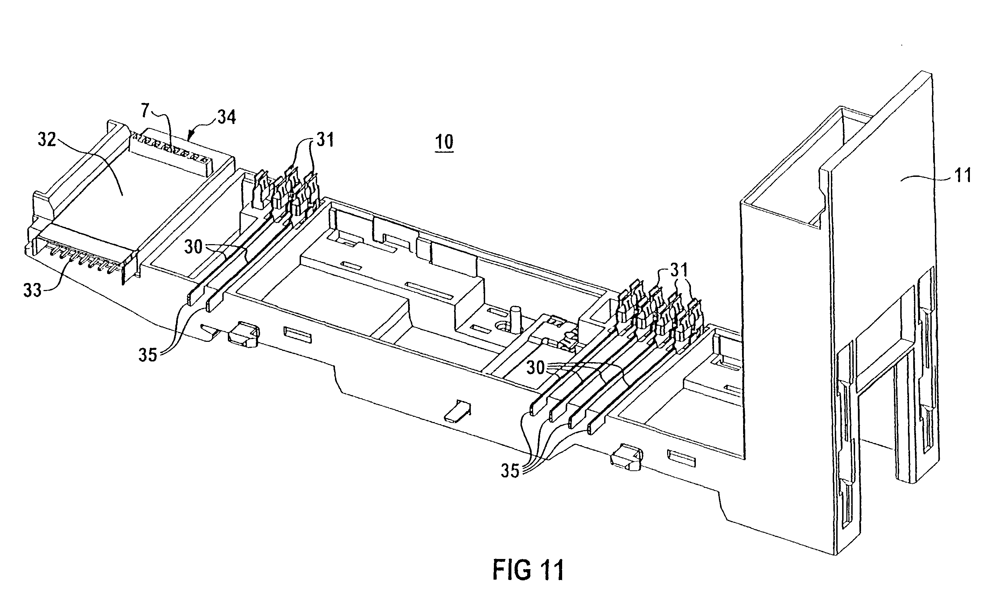

Das L-förmige Trägerteil 10 beinhaltet gemäß FIG 10 und 11 mehrere Stromschienen 30, die als Steuerschienen und Hilfsenergie-Busse mit verschiedenen Spannnungspotentialen dienen können. Diese weisen einerseits nach oben und zur Seite hin anschließbare Lyra-Kontakte 31 auf und andererseits stehen ihre Enden 35 auf der anderen Seite über den Gehäuserand über, um einen Anschluß Seite an Seite über die Lyra-Kontakte 31 eines benachbarten Trägerteils, z.B. einer Ein- bzw. Ausgabebaugruppe 2 zu ermöglichen wie in FIG 10 dargestellt. Außerdem ist im Trägerteil 10 ein Datenbus 32 integriert, der als Leiterplatte mit Strombahnen und seitlichen, endseitig zueinander passenden Anschlüssen in Form einer Stiftleiste 33 und einer Buchsenleiste 34 ausgebildet ist. Die Strombahnen sind außerdem mit einer T-Funktionalität ausgestattet, für die eine weitere nach oben weisende Steckleiste 7 zum elektrischen Anschluß eines Verbraucher-Abzweigs 3 oder einer Ein- bzw. Ausgabebaugruppe 2 vorgesehen ist.

In FIG 10 ist das Trägerteil 10 für eine Abzweig-Baugruppe 3 mit dem Trägerteil 10 einer Ein- bzw. Ausgabe-Baugruppe 2 elektrisch und mechanisch verbunden. Zur Fortführung der Hilfsenergie-Busse weist die Ein-/Ausgabe-Baugruppe 2 Stromschienen 49 mit Steckanschlüssen 50 und Gegensteckanschlüssen 51 auf, entsprechend der Ausführung des Trägerteils 10 für die Abzweig-Baugruppe 3. Die Fortführung des Datenbusses erfolgt über den Datenbus-Abschnitt 37 der Ein-/Ausgabe-Baugruppe 2, mit den zugehörigen Stiftleisten 52 und der Buchsenleiste 53, wobei auch hier die erwähnte T-Funktionalität über die zusätzliche Buchsenleiste 7 zum Anschluß der Ein-/ Ausgabe-Baugruppe 2 geschaffen ist.

## Patentansprüche

1. Verbraucherabzweig (3) zum Schalten und Schützen eines in einem Hauptstromkreis für Spannungen über 100 V anschließbaren Verbrauchers, umfassend eine Abzweig-Baugruppe (6) und ein Trägerteil (10) mit ersten Steckanschlüssen (7,8,9) zum Anschluß an einen Energiebus mit Hauptstromleitungen, an einen Datenbus und erforderlichenfalls an einen Hilfsenergie-Bus, wobei die Abzweig-Baugruppe (6) auf dem Trägerteil (10) mechanisch adaptierbar und über erste Gegensteckanschlüsse (26,27,29) mit den ersten Steckanschlüssen (7,8,9) kontaktierbar ist, **dadurch gekennzeichnet, daß** das Trägerteil als modulares erstes Basis-Unterteil (10) eines modular erweiterbaren Trägersystems mit einem Leitungs- und Bussystem zur Bildung eines Energie-, Daten- und Hilfsenergie-Busses aufgebaut ist und hierzu im ersten Basis-Unterteil (10) erste Leitungs- und/oder Bus-Abschnitte (30,32,36,37,49) mit zugehörigen zweiten Steck- (33,35,48) und Gegensteckanschlüssen (31,34,36) integriert sind, über die zweite Leitungs- und/oder Bus-Abschnitte (30,32,36,37,49) über zugehörige dritte Steck- (33,35,48,50,52) und Gegensteckanschlüsse (31,34,36,51,53) eines entsprechend ausgeführten zweiten Basis-Unterteils (10) bei Erweiterung des Trägersystems kontaktierbar sind (FIG 2,10).

2. Verbraucherabzweig nach Anspruch 1, **dadurch gekennzeichnet, daß** die zweiten Steckanschlüsse (33,35, 48) bzw. Gegensteckanschlüsse (31,34,36) des ersten Basis-Unterteils (10) unmittelbar mit den dritten Steckanschlüssen (33,35,48,50,52) bzw. Gegensteckanschlüssen (31,34,36,51,53) eines zweiten Basis-Unterteils (10) bei dessen Anreihung Seite an Seite an das erste Basis-Unterteil (10) kontaktieren.

3. Verbraucherabzweig nach Anspruch 1 oder 2, **dadurch gekennzeichnet, daß** das zweite Basis-Unterteil (10) zu einer Ein- bzw. Ausgabe-Baugruppe (2) gehört.

4. Verbraucherabzweig nach einem der vorangehenden Ansprüche, **dadurch gekennzeichnet, daß** die den ersten Leitungs- und/oder Bus-Abschnitten (30,32,36,37,49) zugehörigen zweiten Steck- (33,35,48) und Gegensteckanschlüsse (31,34,36) an Seitenwänden des Basis-Unterteils (10) vorgesehen sind.

5. Verbraucherabzweig nach einem der vorangehenden Ansprüche, **dadurch gekennzeichnet, daß** das Basis-Unterteil (10) ein abnehmbares Energiebus-Modul (12) mit Energiebus-Abschnitten (36) aufweist, die im Zuge eines Hauptstromkreises liegen, über den ein Verbraucher an den Verbraucherabzweig (3) anschließbar ist.

6. Verbraucherabzweig nach einem der vorangehenden Ansprüche, **dadurch gekennzeichnet, daß** der Datenbus-Abschnitt (32,37) durch eine Leiterplatte mit Strombahnen realisiert ist, die an einem Ende zu einem Steck-(33,52) und am anderen Ende zu einem Gegensteckanschluß (34,53) zusammengefaßt sind.

7. Verbraucherabzweig nach einem der vorangehenden Ansprüche **dadurch gekennzeichnet, daß** über einen Steckanschluß (7) in Verbindung mit den Strombahnen der Leiterplatte eine T-Funktionalität zum Anschluß der Abzweig-Baugruppe (6) an den Datenbus hergestellt ist.

8. Verbraucherabzweig nach einem der vorangehenden Ansprüche, **dadurch gekennzeichnet, daß** die Abzweig-Baugruppe (6) ein Schütz (16), einen Leistungsschalter (17) und eine Elektronik (25) umfaßt, die über den Datenbus empfangbare Signale in Steuersignale für das Schütz (16) und/oder den Leistungsschalter (17) umsetzt.

9. Verbraucherabzweig nach einem der vorangehenden Ansprüche, **dadurch gekennzeichnet, daß** das Basis-Unterteil (10) einen Führungsschacht (11) mit Steckanschlüssen (9) zum Anschluß an den Energiebus aufweist und die Abzweig-Baugruppe (6) mit einem in den Führungsschacht (11) einführbaren, in seinen Abmessungen diesem entsprechend angepaßten Einführteil (19) mit Gegensteckanschlüssen (29) versehen ist, die bei der mechanischen Adaptierung der Abzweig-Baugruppe (6) auf dem Basis-Unterteil (10) mit den Steckanschlüssen (9) kontaktieren.

## Claims

1. Consumer branch (3) for switching and protecting a consumer which can be connected in a main power circuit for voltages above 100 V, comprising a branch assembly (6) and a mounting unit (10) with first plug-in connectors (7, 8, 9) for connecting to a power bus with main power cables, to a data bus and, if necessary, to an auxiliary power bus, whereby the branch assembly (6) can be mechanically adapted to the mounting unit (10) and can be contacted via the first mating plug-in connectors (26, 27, 29) to the first plug-in connectors (7, 8, 9), **characterised in that** the mounting unit is constructed as a modular first base section (10) of a modularly-expandable mounting system with a cable and bus system for forming a power bus, data bus and auxiliary power bus and integrated into the first base section (10) for this purpose are first cable and/or bus sections (30, 32, 36, 37, 49) with associated second plug-in connectors (33, 35, 48) and mating plug-in connectors (31, 34, 36) through which second cable and/or bus sections (30, 32, 36, 37, 49) can be contacted via associated third plug-in connectors (33, 35, 48, 50, 52) and mating plug-in connectors (31, 34, 36, 51, 53) of a correspondingly-designed second base section (10) when the mounting system is extended (Fig. 2, 10).

2. Consumer branch according to claim 1, **characterised in that** the second plug-in connectors (33, 35, 48) or mating plug-in connectors (31, 34, 36) of the first base section (10) directly contact the third plug-in connectors (33, 35, 48, 50, 52) or mating plug-in connectors (31, 34, 36, 51, 53) of a second base section (10) when arranged in a row side-by-side at the first base section (10).

3. Consumer branch in accordance with claim 1 or 2, **characterised in that** the second base section (10) belongs to an input or output assembly (2).

4. Consumer branch in accordance with one of the preceding claims, **characterised in that** the second plug-in connectors (33, 35, 48) and mating plug-in connectors (31, 34, 36) belonging to the first cable and/or bus sections (30, 32, 36, 37, 49) are provided on sidewalls of the base section (10).

5. Consumer branch in accordance with one of the preceding claims, **characterised in that** the base section (10) has a removable power bus module (12) with power bus sections (36), which are in the path of a main circuit via which a consumer can be connected to the consumer branch (3).

6. Consumer branch in accordance with one of the preceding claims, **characterised in that** the data bus section (32, 37) is implemented by means of a circuit board with conducting tracks which terminate at one end in a plug-in connector (33, 52) and at the other end in a mating plug-in connector (34, 53).

7. Consumer branch in accordance with one of the preceding claims, **characterised in that** a T-functionality for connecting the branch assembly (16) to the data bus is formed by means of a plug-in connector (7) in conjunction with the conducting tracks of the circuit board.

8. Consumer branch in accordance with one of the preceding claims, **characterised in that** the branch assembly (6) includes a contactor (16), a circuit breaker (17) and an electronic circuit (25), which converts signals received via the data bus into control signals for the contactor (16) and/or circuit breaker (17).

9. Consumer branch in accordance with one of the preceding claims,
**characterised in that** the base section (10) has a guide duct (11) with plug-in connectors (9) for connection to the power bus and the branch assembly (6) is provided with an insertion part (19) with mating plug-in connectors (29), whereby the insertion part (19) can be inserted into the guide duct (11) and is dimensionally adapted to this, and whereby the mating plug-in connectors (29) contact the plug-in connectors (9) when the branch assembly (6) on the base section (10) is mechanically adapted.

## Revendications

1. Circuit de branchement de consommateur (3) qui est destiné à brancher et protéger un consommateur pouvant être raccordé à un circuit de courant principal pour des tensions supérieures à 100 V et qui comprend un module de branchement (6) et un support (10) ayant des premiers connecteurs embrochables (7, 8, 9) pour le raccordement à un bus d'énergie ayant des lignes de courant principal, à un bus de données et si nécessaire à un bus d'énergie auxiliaire, le module de branchement (6) pouvant être adapté de façon mécanique sur le support (10) et pouvant être mis en contact avec les premiers connecteurs embrochables (7, 8, 9) par l'intermédiaire de premiers connecteurs complémentaires (26, 27, 29), **caractérisé par** le fait que le support est construit en tant que première substructure de base modulaire (10) d'un système de support à extension modulaire ayant un système de lignes et de bus pour la formation d'un bus d'énergie, d'un bus d'énergie auxiliaire et d'un bus de données et qu'il est intégré à cet effet dans la première substructure de base (10) des premiers tronçons de lignes et/ou de bus (30, 32, 36, 37, 49) ayant des deuxièmes connecteurs (33, 35, 48) et connecteurs complémentaires (31, 34, 36) associés par l'intermédiaire desquels des deuxièmes tronçons de lignes et/ou de bus (30, 32, 36, 37, 49) peuvent être mis en contact par l'intermédiaire de troisièmes connecteurs (33, 35, 48, 50, 52) et connecteurs complémentaires (31, 34, 36, 51, 53) associés d'une deuxième substructure de base (10), réalisée de manière correspondante, lors de l'extension du système de support (figures 2, 10).

2. Circuit de branchement de consommateur selon la revendication 1, **caractérisé par** le fait que les deuxièmes connecteurs (33, 35, 48) et connecteurs complémentaires (31, 34, 36) de la première substructure de base (10) sont mis en contact directement avec les troisièmes connecteurs (33, 35, 48, 50, 52) et connecteurs complémentaires (31, 34, 36, 51, 53) d'une deuxième substructure de base (10) lors de la juxtaposition de celle-ci à côté de la première substructure de base (10).

3. Circuit de branchement de consommateur selon la revendication 1 ou 2, **caractérisé par** le fait que la deuxième substructure de base (10) appartient à un module d'entrée/sortie (2).

4. Circuit de branchement de consommateur selon l'une des revendications précédentes, **caractérisé par** le fait que les deuxièmes connecteurs (33, 35, 48) et connecteurs complémentaires (31, 34, 36) associés aux premiers tronçons de lignes et/ou de bus (30, 32, 36, 37, 49) sont prévus sur les parois latérales de la substructure de base (10).

5. Circuit de branchement de consommateur selon l'une des revendications précédentes, **caractérisé par** le fait que la substructure de base (10) comporte un module de bus d'énergie amovible (12) ayant des tronçons de bus d'énergie (36) qui se trouvent dans le circuit de courant principal par l'intermédiaire duquel un consommateur peut être raccordé au circuit de branchement de consommateur (3).

6. Circuit de branchement de consommateur selon l'une des revendications précédentes, **caractérisé par** le fait que le tronçon de bus de données (32, 37) est réalisé par une carte de circuits imprimés ayant des pistes de courant qui sont regroupées à une extrémité en un connecteur (33, 52) et à l'autre extrémité en un connecteur complémentaire (34, 53).

7. Circuit de branchement de consommateur selon l'une des revendications précédentes, **caractérisé par** le fait qu'une fonctionnalité en T pour le raccordement du module de branchement (6) au bus de données est créée par l'intermédiaire d'un connecteur (7) en liaison avec les pistes de courant de la carte de circuits imprimés.

8. Circuit de branchement de consommateur selon l'une des revendications précédentes, **caractérisé par** le fait que le module de branchement (6) comprend un contacteur (16), un interrupteur de puissance (17) et une unité électronique (25) qui convertit des signaux pouvant être reçus par l'intermédiaire du bus de données en signaux de commande pour le contacteur (16) et/ou pour l'interrupteur de puissance (17).

9. Circuit de branchement de consommateur selon l'une des revendications précédentes, **caractérisé par** le fait que la substructure de base (10) comporte une gaine de guidage (11) ayant des connecteurs (9) pour le raccordement au bus d'énergie et que le module de branchement (6) est muni d'une partie à insérer (19) ayant des connecteurs complémentaires (29) qui peut être insérée dans la gaine de guidage (11) et qui est adaptée à celle-ci quant à ses dimensions, lesquels connecteurs complémentaires font contact avec les connecteurs (9) lors de l'adaptation mécanique du module de branchement (6) sur la substructure de base (10).
